# FASCICULE DE BREVET EUROPEEN

(11) **EP 3 681 037 B1**
(45) Date de publication et mention de la délivrance du brevet: **20.12.2023**
(21) Numéro de dépôt: 20151366.0
(22) Date de dépôt: 13.01.2020
(51) Int. Cl.: H03D 1/18, G01R 19/04, H04L 27/06

(54) **CIRCUIT ÉLECTRONIQUE DE DÉTECTION D'ENVELOPPE ET DÉMODULATEUR CORRESPONDANT**
ELEKTRONISCHER SCHALTKREIS ZUR HÜLLKURVENERFASSUNG, UND ENTSPRECHENDER DEMODULATOR
ELECTRONIC CIRCUIT FOR DETECTING AN ENCLOSURE AND CORRESPONDING DEMODULATOR

(30) Priorité: 14.01.2019 FR 1900307
(43) Date de publication de la demande: 15.07.2020
(60) Demande divisionnaire: 23163078.1
(73) Titulaire: STMICROELECTRONICS SA, 92120 Montrouge (FR)
(72) Inventeur: VOGT, Lionel, 73110 LA ROCHETTE (FR)
(74) Mandataire: Casalonga

(56) Documents cités:
- EP-A1- 2 874 309
- EP-A2- 2 713 171
- CN-A- 106 712 729
- JP-A- S5 779 715
- US-A1- 2006 255 860
- US-A1- 2008 084 956
- US-A1- 2017 343 589

## Description

Des modes de réalisation de l'invention concernent les circuits électroniques, plus particulièrement les circuits électroniques de détection d'enveloppe susceptibles d'être incorporés dans les démodulateurs radiofréquences (« Radio Frequency Demodulator » en langue anglaise) pour les applications de communication sans fil.

D'une façon générale, un circuit électronique de détection d'enveloppe, ou en d'autres termes un détecteur d'enveloppe, a pour objectif d'extraire un signal basse fréquence d'un signal de porteuse, par exemple un signal de porteuse radiofréquence, modulée en amplitude.

Les détecteurs d'enveloppe sont généralement utilisés dans les démodulateurs de type modulation par décalage d'amplitude, communément connue de l'homme du métier sous l'acronyme anglais : ASK (« Amplitude-Shift Keying » en langue anglaise).

Ce type de démodulateur est capable de traiter un grand débit de données, par exemple de l'ordre de plusieurs gigabits par seconde, et d'effectuer des démodulations non-cohérentes tout en permettant une consommation faible. Ces caractéristiques techniques sont particulièrement avantageuses pour des applications de communication sans fil, par exemple des connections sans fil à ondes millimétriques à courte portée (« Short-Range millimiter-wave wireless link » en langue anglaise).

Un détecteur d'enveloppe classique peut par exemple être basé sur la non-linéarité d'un dispositif électronique et peut comporter un amplificateur dans une configuration de source commune.

L'amplificateur d'un tel détecteur d'enveloppe requiert cependant un point de polarisation (« Biasing point » en anglais) précis de façon à maximiser le gain de conversion et possède une gamme dynamique (« Dynamic Range » en langue anglaise) assez limitée.

Ce point de polarisation est important pour que la puissance moyenne d'un signal d'entrée radiofréquence du détecteur d'enveloppe ne dépasse pas la gamme dynamique du détecteur d'enveloppe et ce afin d'extraire un signal basse fréquence avec une amplitude suffisante mais sans écrêtage (« clipping » en langue anglaise).

En pratique, il est difficile voire irréalisable de configurer une fois pour toutes un tel point de polarisation précis de l'amplificateur à cause d'éventuelles variations sur la puissance moyenne du signal d'entrée radiofréquence du détecteur d'enveloppe, sur le procédé de fabrication du détecteur d'enveloppe, ou sur la température à proximité du détecteur d'enveloppe.

Il existe également des solutions techniques classiques qui proposent un étage de rétroaction configuré pour adapter la variation d'un signal de sortie du détecteur d'enveloppe en courant continu (« Direct Current » : DC en langue anglaise) en fonction de la puissance moyenne du signal d'entrée radiofréquence du détecteur d'enveloppe.

Cependant, un tél étage de rétroaction est généralement complexe. En outre, le point de polarisation du détecteur d'enveloppe destiné à recevoir le signal d'entrée radiofréquence n'est pas variable et souvent mal adapté au signal d'entrée à cause de l'effet de canal court du transistor de l'amplificateur.

Par conséquent, le gain de conversion, autrement dit la sensibilité, et la gamme dynamique du détecteur d'enveloppe ne peuvent pas être maximisés. Lors d'une variation de la puissance moyenne du signal d'entrée radiofréquence, il en résulte souvent une distorsion du signal de sortie du détecteur d'enveloppe.

Il existe ainsi un besoin de proposer une solution technique à faible complexité, à faible consommation d'énergie, et à faible surface de silicium permettant d'adapter de façon dynamique le point de polarisation et le gain de conversion d'un détecteur d'enveloppe en fonction de la puissance moyenne du signal d'entrée du détecteur d'enveloppe de façon à étendre la gamme dynamique du détecteur d'enveloppe.

A titre d'exemple non limitatif, des exemples pour des circuits électroniques de détection d'enveloppe dans l'art antérieur sont divulgués dans les documents de brevet US 2017/343589 A1, US 2008/084956 A1, CN 106 712 729 A, JP S57 79715 A ainsi que EP 2 713 171 A2.

Selon l'invention, il est proposé un circuit électronique de détection d'enveloppe selon la revendication 1.

Ce circuit électronique de détection d'enveloppe comprend un étage de détection comportant au moins un transistor MOS configuré pour recevoir un signal d'entrée radiofréquence et pour délivrer un signal interne à partir du signal d'entrée, la tension moyenne de polarisation de grille dudit au moins un transistor étant contrôlée par un signal de commande, et un étage de traitement couplé à l'étage de détection et configuré pour délivrer un signal de sortie basse fréquence à partir du signal interne et pour délivrer le signal de commande à partir du signal interne, de façon à ce que la valeur du signal de commande diminue lorsque la puissance moyenne du signal d'entrée augmente, et vice versa.

La valeur du signal de commande correspond avantageusement à la moyenne de la tension de polarisation de grille dudit au moins un transistor.

Le signal d'entrée contrôle avantageusement la valeur instantanée de cette tension de polarisation de grille.

Ainsi un tel circuit permet avantageusement d'adapter la polarisation de l'étage de détection à la puissance moyenne du signal reçu, c'est-à-dire le signal d'entrée, et ainsi augmenter la dynamique de réception.

En d'autres termes, un tel circuit permet avantageusement, en fonction de la variation de la puissance moyenne du signal d'entrée, un réglage dynamique du point de polarisation dudit au moins un transistor de l'étage de détection de façon à adapter le point de polarisation dudit au moins un transistor à la puissance moyenne du signal d'entrée radiofréquence.

De ce fait, le gain de conversion dudit circuit électronique de détection d'enveloppe est dynamiquement adapté à la variation de la puissance moyenne du signal d'entrée.

Autrement dit, lorsque la puissance moyenne du signal d'entrée augmente, la valeur dudit au moins un signal de commande va diminuer de façon à rattraper la variation de ladite puissance moyenne du signal d'entrée. Par conséquent, ledit point de polarisation est plus ou moins adapté et peu influencé par ladite variation.

Ainsi, le circuit électronique de détection d'enveloppe peut adapter de façon dynamique à la variation de la puissance moyenne du signal d'entrée et la gamme dynamique (« Dynamic Range » en langue anglaise) du circuit électronique de détection d'enveloppe est étendue.

Selon l'invention, l' étage de détection comprend aussi un premier transistor MOS de type N et un deuxième transistor MOS de type N dont les drains sont conjointement couplés à l'étage de traitement, et un transformateur comportant un enroulement d'entrée destiné à recevoir le signal d'entrée, un premier enroulement de sortie couplé à l'étage de traitement et aux grilles des premier et deuxième transistors, et un deuxième enroulement de sortie couplé aux sources des premier et deuxième transistors, le premier enroulement de sortie étant destiné à recevoir un signal de commande.

Les premier et deuxième transistors forment en effet un mélangeur (« mixer » en Anglais) destiné à recevoir le signal d'entrée sur les grilles et sur les sources de manière à multiplier le signal d'entrée par lui-même et ainsi, en l'élevant au carrée, implémenter une détection d'enveloppe. Les grilles des premier et deuxième transistors sont destinées à être contrôlées par le signal d'entrée et le signal de commande via le premier enroulement de sortie.

Le premier enroulement de sortie peut par exemple comporter un premier noeud médian situé au milieu du premier enroulement de sortie et destiné à recevoir le signal de commande.

Le deuxième enroulement de sortie peut par exemple comporter un deuxième noeud médian situé au milieu du deuxième enroulement de sortie et couplé à la masse.

L'utilisation d'un tel transformateur à trois voies (« Three Way Tranformer » en langue anglaise) permet avantageusement d'appliquer le signal d'entrée radiofréquence et le signal de commande sur les grilles et les sources des premier et deuxième transistors de façon à contrôler le point de polarisation des premier et deuxième transistors et d'obtenir une efficacité de conversion élevée de l'étage de détection.

Le nombre de spires du premier enroulement de sortie peut être par exemple plus grand que le nombre de spires de l'enroulement d'entrée et que le nombre de spires du deuxième enroulement de sortie, ce qui permet avantageusement augmenter la sensibilité de l'étage de détection.

A titre indicatif mais pas limitatif, l'étage de traitement peut par exemple comprendre un amplificateur transimpédance destiné à recevoir le signal interne.

La fréquence du signal d'entrée radiofréquence peut par exemple être de l'ordre de 60 GHz.

Selon un autre aspect, il est proposé un démodulateur incorporant un circuit électronique de détection d'enveloppe tel que défini ci-avant.

A titre d'exemple non limitatif, le démodulateur peut par exemple être un démodulateur de type de modulation par décalage d'amplitude.

Selon un autre aspect, il est proposé un récepteur radiofréquence sans fil comprenant un démodulateur tel que défini ci-dessus.

Selon encore un autre aspect, il est proposé un appareil de communication sans fil comprenant un récepteur radiofréquence tel que défini ci-dessus.

D'autres avantages et caractéristiques de l'invention apparaîtront à l'examen de la description détaillée de modes de réalisation, nullement limitatifs, et des dessins annexés sur lesquels :
[Fig 1] illustre schématiquement un mode de réalisation de l'invention,
[Fig 2] illustre schématiquement un mode de réalisation de l'invention,
[Fig 3] illustre schématiquement un résultat de simulation d'un mode de réalisation de l'invention,
[Fig 4] illustre schématiquement un résultat de simulation d'un mode de réalisation de l'invention,
[Fig 5] illustre schématiquement un exemple comparative non-revendiqué,
[Fig 6] illustre schématiquement un autre exemple comparative non-revendiqué,

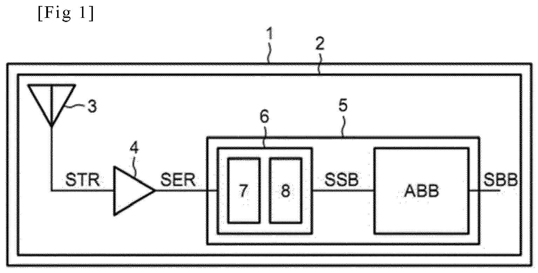

La figure 1 illustre un appareil de communication sans fil 1, ici par exemple basé sur la technologie de connections sans fil à ondes millimétriques à courte portée (« Short-Range millimiter-wave wireless link » en langue anglaise).

Cet appareil 1 est configuré pour effectuer des communications sans fil à grand débit, par exemple de plusieurs gigabits par seconde dans une portée courte, par exemple de l'ordre de 10 centimètres de façon à remplacer des communications de données via des câbles, par exemple de type de bus universel en série, communément connu de l'homme du métier sous l'acronyme anglo-saxon USB (« Universal Serial Bus » en langue anglaise).

Sans contrainte d'alignement mécanique, l'appareil 1 peut avantageusement être utilisé pour des dispositifs industriels ou grand public à faible encombrement et/ scellés.

L'appareil 1 comprend un récepteur radiofréquence sans fil 2 comportant
une antenne 3 recevant un signal de transmission radiofréquence STR, un amplificateur faible bruit 4 (« Low Noise Amplifier » en langue anglaise) couplé à l'antenne 3 et configuré pour mettre en forme le signal de transmission radiofréquence STR de façon à délivrer un signal d'entrée radiofréquence SER, et
un démodulateur 5, ici par exemple de type modulation par décalage d'amplitude (« Amplitude-Shift Keying » : ASK en langue anglaise), plus particulièrement de type modulation en tout ou rien (« On-Off Keying » : OOK en langue anglaise), configuré pour délivrer à partir du signal d'entrée SER un signal en bande de basse SBB.

Le démodulateur 5 comporte un circuit électronique de détection d'enveloppe 6 et un amplificateur en bande de base ABB (« Baseband Amplifier » en langue anglaise).

Le circuit électronique de détection d'enveloppe 6 est destiné à recevoir le signal d'entrée SER et configuré pour délivrer à l'amplificateur en bande de base ABB, un signal de sortie basse fréquence SSB.

L'amplificateur de bande de base est configuré pour amplifier ensuite le signal de sortie basse fréquence SSB de façon à générer le signal de sortie SBB.

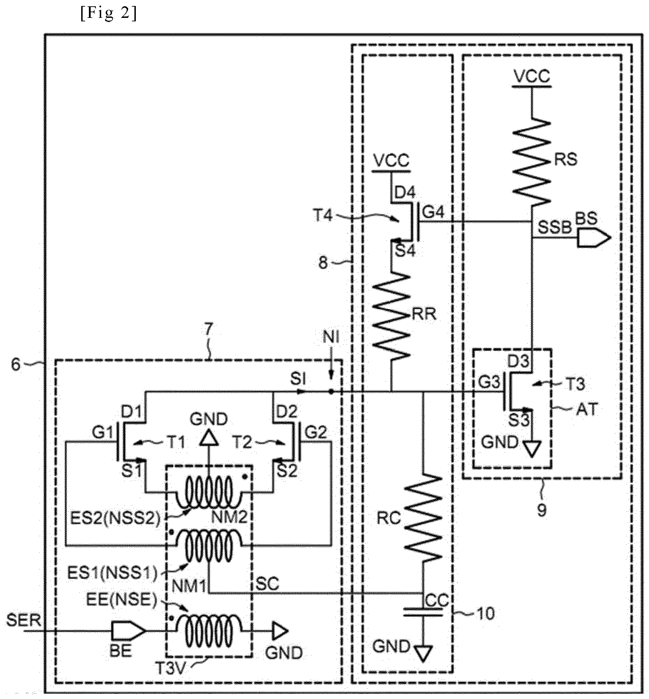

On se réfère à la figure 2 pour illustrer plus en détails un exemple de réalisation préféré du circuit électronique de détection d'enveloppe 6 comportant un étage de détection 7 et un étage de traitement 8.

L'étage de détection 7 comporte
une paire différentielle comprenant un premier transistor T1 MOS de type N et un deuxième transistor T2 MOS de type N,
un transformateur à triple voies T3V (« Three way transformer » en langue anglaise) couplé à la paire différentielle.

Le transformateur T3V comprend
un enroulement d'entrée EE couplé entre la masse GND et une borne d'entrée BE destinée à recevoir le signal d'entrée radiofréquence SER,
un premier enroulement de sortie ES1 couplé entre les grilles G1, G2 des premier et deuxième transistors T1, T2, et
un deuxième enroulement de sortie ES2 couplé entre les sources S1, S2 des premier et deuxième transistor T1, T2.

Il convient de noter que le signal d'entrée radiofréquence SER peut également être appliqué de façon différentielle aux bornes de l'enroulement.

Le premier enroulement de sortie ES1 comporte un premier noeud médian NM1 situé au milieu du premier enroulement de sortie ES1 et couplé à l'étage de traitement 8. Le premier noeud médian NM1 est destiné à recevoir un signal de commande SC délivré par l'étage de traitement 8.

Le premier enroulement de sortie ES1 est configuré pour délivrer aux grilles G1, G2 des premier et deuxième transistors T1, T2 une tension de grille différentielle à partir du signal d'entrée SER et du signal de commande SC.

Autrement dit, le point de polarisation des premier et deuxième transistors T1, T2 est contrôlé par le signal d'entrée SER et le signal de commande SC.

Comme on le verra plus en détails ci-après, le signal de commande SC est un signal en tension destiné à ajuster la puissance moyenne, en mode commun, du signal d'entrée radiofréquence SER.

Le deuxième enroulement de sortie ES2 comporte un deuxième noeud médian NM2 situé au milieu du deux enroulement de sortie ES2 et couplé à la masse GND.

Le deuxième enroulement de sortie ES2 est configuré pour délivrer aux sources S1, S2 des premier et deuxième transistors T1, T2 une tension de source différentielle à partir du signal d'entrée SER.

Il convient de noter que les directions des spires de l'enroulement d'entrée EE1 et du premier enroulement de sortie ES1 sont identiques tandis que la direction des spires du deuxième enroulement est opposée à celle de l'enroulement d'entrée EE1 et du premier enroulement de sortie ES1.

A titre d'exemple non limitatif, le nombre de spires NSS1 du premier enroulement de sortie ES1 est plus grand que le nombre de spires NSE de l'enroulement d'entrée EE et que le nombre de spires NSS du deuxième enroulement de sortie ES2 de façon augmenter la sensibilité de l'étage de détection 7.

L'étage de détection 7 comporte en outre un noeud intermédiaire NI couplé aux drains D1, D2 des premier et deuxième transistors T1, T2 et l'étage de détection 7 est configuré pour délivrer au noeud intermédiaire NI un signal interne SI en courant qui est la combinaison des courants de drain des premier et deuxième transistors T1, T2.

L'étage de traitement 8 comporte un module de sortie 9 et un module de rétroaction 10.

Le module de sortie 9 comprend un amplificateur transimpédance AT communément connu de l'homme du métier.

L'amplificateur transimpédance AT comporte ici par exemple un troisième transistor MOS T3 de type N dont la grille G3 est couplée au noeud intermédiaire NI, dont la source S3 est couplée à la masse GND, et dont le drain D3 est couplé à une borne de sortie BS, et une résistance de sortie RS couplée entre une tension d'alimentation VCC et la borne de sortie BS.

La dimension du troisième transistor T3 est convenablement choisie pour être adaptée aux celles des premier et deuxième transistors T1 et T2 de façon à assurer que la tension de grille VG3 du troisième transistor T3 soit adaptée pour faire fonctionner les premier et deuxième transistors T1 et T2.

Le courant de drain du troisième transistor T3 est approximativement proportionnel au signal interne SI. Le module de sortie 9 est configuré pour convertir le courant de drain en le signal de sortie basse fréquence SSB en tension sur la borne de sortie BS par l'intermédiaire de la résistance de sortie RS.

En d'autres termes, l'amplificateur transimpédance AT est configuré pour délivrer à la borne de sortie BS le signal de sortie basse fréquence SSB en tension à partir du signal interne SI en courant.

Le module de rétroaction 10 comprend
un quatrième transistor MOS T4 de type N dont la grille G4 est couplée à la borne de sortie BS, dont le drain D4 est couplé à la tension d'alimentation VCC, et dont la source S4 est couplée au noeud intermédiaire NI via une résistance de rétroaction RR,
une résistance de commande RC couplée entre le noeud intermédiaire NI et le premier noeud médian NM1, et
un condensateur de commande CC couplé entre le premier noeud médian NM1 et la masse GND.

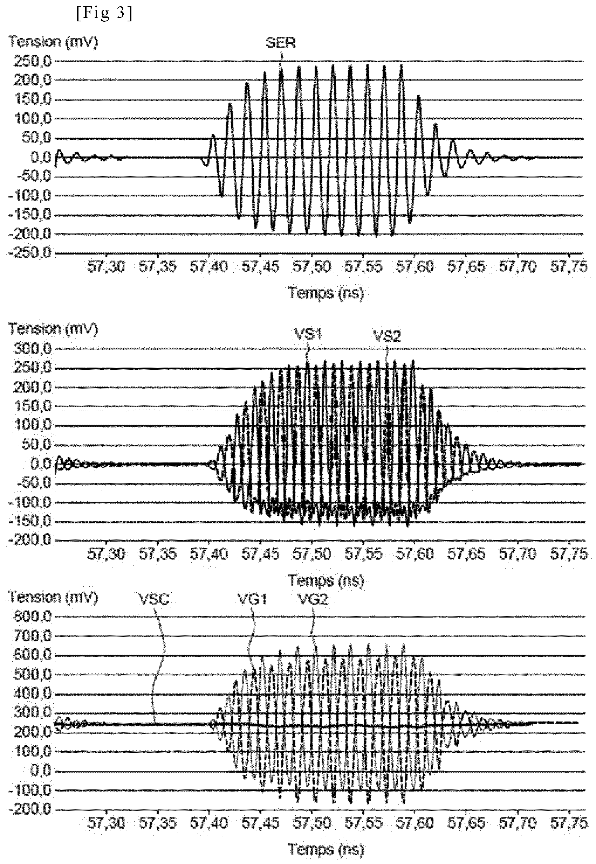

On se réfère maintenant à la figure 3 pour illustrer schématiquement un exemple de simulation dudit circuit électronique de détection d'enveloppe 6.

On peut observer sur la partie supérieure de la figure 3 un exemple du signal d'entrée SER en tension. La fréquence de la porteuse du signal d'entrée SER est ici par exemple à 60 GHz et le signal d'entrée SER est modulé par un flux binaire de 5Gb/s en modulation par décalage d'amplitude (« Amplitude-Shift Keying » : ASK en langue anglaise).

Les tensions de sources VS1, VS2 des premier et deuxième transistors T1, T2 sont illustrées au-dessous du signal d'entrée SER.

Comme les nombres de spires NSE, NSS2 de l'enroulement d'entrée EE et du deuxième enroulement de sortie ES2 sont identiques et que les directions de l'enroulement d'entrée EE et du deuxième enroulement de sortie ES2 sont opposées, l'amplitude de la tension de source VS2 du deuxième transistor T2 est sensiblement identique à celle du signal d'entrée SER tandis que l'amplitude de la tension de source VS1 du premier transistor T1 est sensiblement opposée à celle du signal d'entrée SER.

De la même façon, comme le nombre de spires NS1 du premier enroulement de sortie ES1 est supérieur à celui de l'enroulement d'entrée EE et que les directions de l'enroulement d'entrée EE et du premier enroulement de sortie ES1 sont identiques, l'amplitude de la tension de grille VG1 du premier transistor T1 est supérieure à celle du signal d'entrée SER tandis que l'amplitude de la tension de grille VG2 du deuxième transistor T2 est sensiblement opposée à celle du premier transistor T1.

On peut également constater que la valeur VSC du signal de commande SC correspond à la moyenne des tensions de grille VG1, VG2 des premier et deuxième transistors T1, T2.

Lorsque la puissance moyenne du signal d'entrée SER augmente, la valeur du signal interne SI et la valeur moyenne du signal de sortie basse fréquence SSB vont augmenter tandis que la valeur VSC du signal de commande SC va diminuer de façon à baisser le point de polarisation de l'étage de détection. De ce fait, la gamme dynamique de l'étage de détection est étendue.

A l'inverse, lorsque la puissance moyenne du signal d'entrée SER diminue, la valeur du signal interne SI et la valeur du signal de sortie basse fréquence SSB vont également diminuer tandis que la valeur VSC du signal de commande SC va augmenter de façon à compenser la variation de la puissance moyenne du signal d'entrée SER.

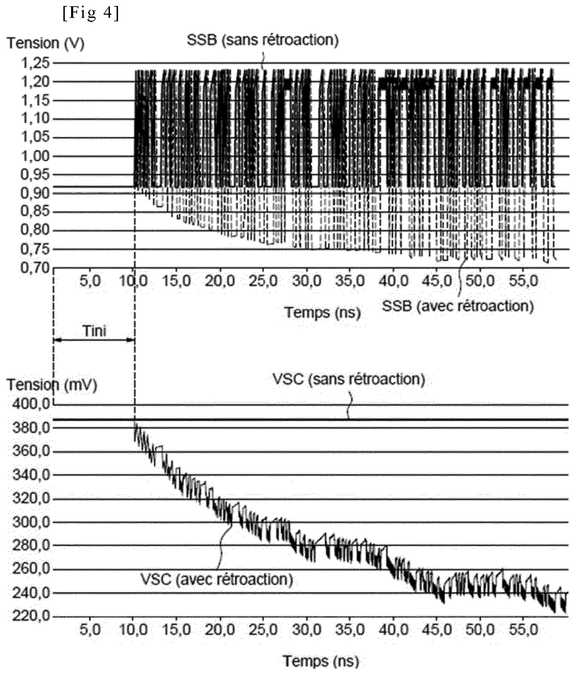

On se réfère maintenant à la figure 4 pour illustrer schématiquement un autre exemple de simulation dudit circuit électronique de détection d'enveloppe 6.

Pendant une période initiale Tini, la valeur du signal de sortie SSB est constante (valeur DC) parce que celle du signal d'entrée SER est nulle.

La puissance moyenne du signal d'entrée SER est ensuite augmentée de façon à augmenter les valeurs des courants de drain des premier et deuxième transistors T1, T2. La valeur du signal interne SI est par conséquent augmentée.

Le module de sortie 9 est configuré pour générer à partir du signal interne SI le signal de sortie SSB en tension.

La valeur du signal de sortie SSB est donc aussi augmentée de façon à augmenter la valeur du courant de source du quatrième transistor T4.

A titre indicatif, la valeur du signal de sortie SSB est ici saturée car l'amplitude du signal d'entée SER est déjà trop grande.

Comme le gain de l'amplificateur à transimpédance est limité, ici par exemple par les valeurs de la résistance de rétroaction RR et les dimensions du transistor MOS T4 ainsi que par le gain de boucle ouverte donné par le troisième transistor T3 et la résistance de sortie RS, la tension moyenne de grille VG3 du troisième transistor T3 et la valeur VSC du signal de commande SC vont en conséquence diminuer, et ce d'autant plus que la sortie BS du module de sortie 9 s'approche de la saturation, ce qui a pour effet de réduire le gain de boucle ouverte formé par le troisième transistor T3 et la résistance de sortie RS.

Comme indiqué ci-avant, la valeur VSC du signal de commande SC correspond à la moyenne des tensions de grille VG1, VG2 des premier et deuxième transistors T1, T2.

La diminution de ladite valeur VSC du signal de commande SC conduit à la diminution de la moyenne des tensions de grille VG1, VG2 des premier et deuxième transistors T1, T2.

Autrement dit, le point de polarisation de l'étage de détection est diminué en suivant la variation de la valeur VSC du signal de commande SC.

On peut également constater sur la figure 4 un autre exemple de la tension VSC du signal de commande SC dans un cas où le circuit électronique de détection d'enveloppe 6 fonctionne sans le module de rétroaction 10.

Dans cet exemple, la gamme de variation du signal de sortie SSB selon l'invention est étendue et la valeur du signal de sortie SSB oscille autour de sa valeur continue (DC), ce qui permet avantageusement une meilleure qualité de démodulation, notamment pour restituer un signal binaire en comparant le signal de sortie SSB à un seuil proche de sa valeur continue (DC), et une distorsion réduite au niveau du signal de sortie basse fréquence SSB. Une telle distorsion peut dégrader la gigue (« jitter » en anglais) du signal binaire démodulé.

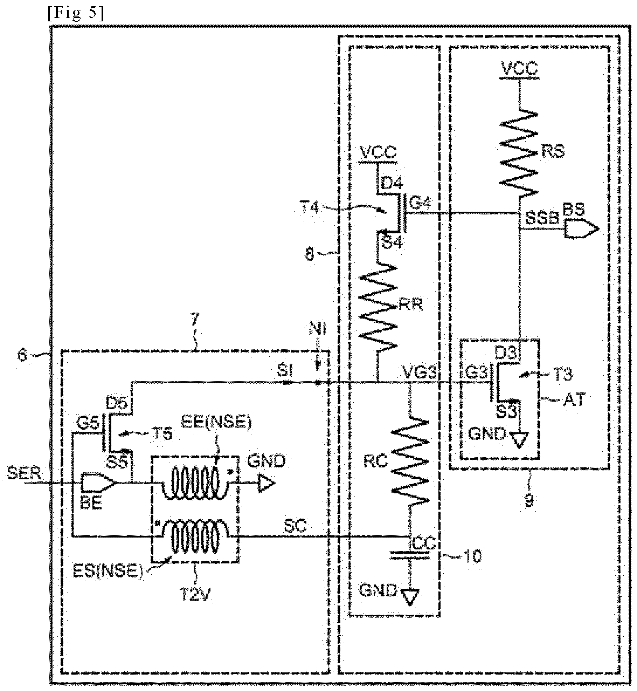

En variante, on illustre sur la figure 5 un autre exemple de réalisation du circuit électronique de détection d'enveloppe 6.

A titre indicatif, ce circuit électronique de détection d'enveloppe 6 peut par exemple avoir le même étage de traitement 8 illustré sur la figure 2.

L'étage de détection 7 de ce circuit électronique de détection d'enveloppe 6 comprend un cinquième transistor T5 MOS de type N dont le drain D5 est couplé au noeud intermédiaire NI relié à la grille G3 du troisième transistor T3, dont la source S5 est couplée à la masse via un enroulement d'entrée EE d'un transformateur à double voie T2V, et dont la grille G5 est couplée au module de rétroaction 10 via un enroulement de sortie ES du transformateur T2V.

L'étage de détection 7 reçoit le signal d'entrée radiofréquence SER à la source S5 du cinquième transistor T5.

La direction de spires de l'enroulement d'entrée EE est opposée à celle de spires de l'enroulement de sortie ES. Le nombre des spires de l'enroulement d'entrée EE est par exemple moins grand que celui des spires de l'enroulement de sortie ES de façon à améliorer la sensibilité de l'étage de détection 7.

De ce fait, la tension de grille VG5 du cinquième transistor T5 est contrôlée par le signal d'entrée SER.

L'enroulement de sortie ES est également destiné à recevoir le signal de commande SC délivré par l'étage de traitement 8.

En d'autres termes, la tension de grille VG5 du cinquième transistor T5 est également contrôlée par le signal de commande SC. Le point de polarisation du cinquième transistor T5 est par conséquent contrôlé par le signal d'entrée SER et par le signal de commande SC.

Lorsque la puissance moyenne du signal d'entrée SER augmente, le courant de drain du cinquième transistor T5, autrement dit le signal interne SI, augmente aussi.

Dans ce cas là, l'étage de traitement 8 est configuré pour augmenter la valeur du signal de sortie SSB et diminuer la valeur du signal de commande SC de façon à diminuer la moyenne de la tension de grille VG5 du cinquième transistor T5.

Ainsi, le circuit électronique de détection d'enveloppe 6 est capable d'adapter à la variation de la puissance moyenne du signal d'entrée SER de façon à modifier dynamiquement le point de polarisation et le gain de conversion de l'étage de détection 7. La gamme dynamique dudit circuit 6 est donc également étendue.

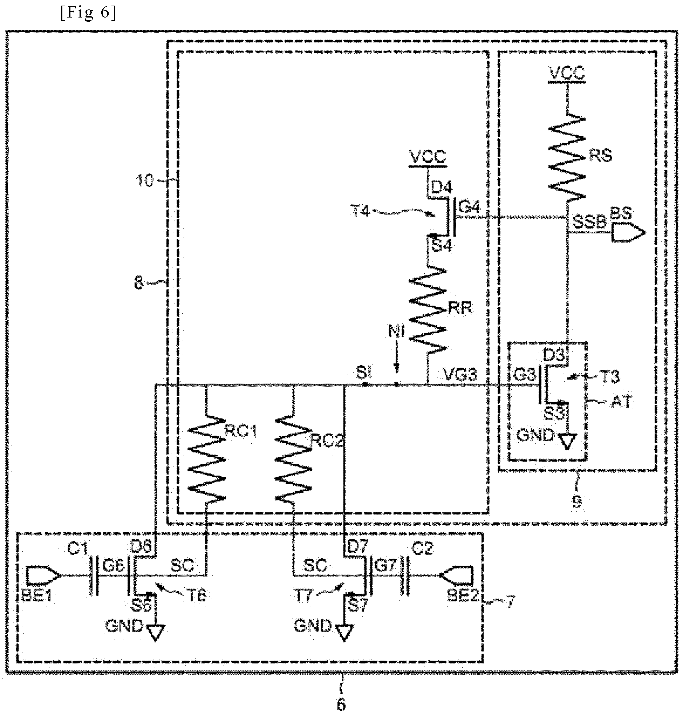

On se réfère maintenant à la figure 6 pour illustrer un autre exemple de réalisation du circuit électronique de détection d'enveloppe 6.

L'étage de traitement 8 est similaire à celui illustré sur les figures 2 et 5 et l'étage de détection 7 comporte un sixième transistor T6 MOS de type N et un septième transistor T7 MOS de type N.

Les drains des sixième et septième transistors T6, T7 sont conjointement couplés au noeud intermédiaire NI de façon à délivrer à audit noeud intermédiaire NI le signal interne SI. Les sources des sixième et septième transistors T6, T7 sont couplées à la masse GND.

La grille G6 du sixième transistor T6 est couplée au noeud intermédiaire NI via une première résistance de commande RC1 et la grille G6 du sixième transistor T6 est en outre couplée à une première borne d'entrée BE1 via un premier condensateur C1.

De la même façon, la grille G7 du septième transistor T7 est couplée au noeud intermédiaire NI via une deuxième résistance de commande RC2. La grille G7 du septième transistor T7 est en outre couplée à une deuxième borne d'entrée BE2 via un deuxième condensateur C2.

Les première et deuxième résistances de commande RC1, RC2 sont identiques et les grilles G6, G7 des sixième et septième transistors T6, T7 sont destinées à recevoir le même signal de commande SC.

L'étage de détection 7 est configuré pour recevoir le signal d'entrée radiofréquence SER en différentiel via les premier et deuxième condensateurs C1, C2.

Si la puissance moyenne du signal d'entrée SER diminue, le signal interne SI diminue également.

Le module de sortie 9 est configuré pour convertir le signal interne SI en signal de sortie SSB et la valeur du signal de sortie SSB diminue également, ce qui conduit à une augmentation de la tension de grille VG3 du troisième transistor T3.

La valeur du signal de commande SC est par conséquent augmentée de façon à modifier le point de polarisation de l'étage de détection 6.

De la même façon, une augmentation de la puissance moyenne du signal d'entrée radiofréquence SER conduit à une diminution de la valeur du signal de commande SC.

Ainsi, on obtient un circuit électronique de détection d'enveloppe capable d'adapter dynamiquement le point de polarisation et le gain de conversion dudit circuit à la variation de la puissance moyenne du signal d'entrée dudit circuit électronique de détection d'enveloppe de façon à étendre sa gamme dynamique.

## Revendications

1. Circuit électronique de détection d'enveloppe, comprenant un étage de détection (7) comportant au moins un transistor MOS (T1, T2, T5, T6, T7) configuré pour recevoir un signal d'entrée radiofréquence (SER) et pour délivrer un signal interne (SI) à partir du signal d'entrée (SER), la tension moyenne de polarisation de grille dudit au moins un transistor (T1, T2, T5, T6, T7) étant contrôlée par un signal de commande (SC), et
un étage de traitement (8) couplé à l'étage de détection (7) et configuré pour délivrer un signal de sortie (SSB) basse fréquence à partir du signal interne (SI) et pour délivrer le signal de commande (SC) à partir du signal interne (SI), de façon à ce que la valeur du signal de commande (SC) diminue lorsque la puissance moyenne du signal d'entrée (SER) augmente, et vice versa,
**caractérisé par** l'étage de détection (7) comprenant :
un premier transistor MOS (T1) de type N et un deuxième transistor MOS (T2) de type N dont les drains (D1, D2) sont conjointement couplés à l'étage de traitement (8), et
un transformateur (T3 V) comportant un enroulement d'entrée (EE) destiné à recevoir le signal d'entrée (SER), un premier enroulement de sortie (ES1) couplé à l'étage de traitement (8) et aux grilles (G1, G2) des premier et deuxième transistors (T1, T2), et un deuxième enroulement de sortie (ES2) couplé aux sources (S1, S2) des premier et deuxième transistors (T1, T2), le premier enroulement de sortie (ES1) étant destiné à recevoir le signal de commande (SC).

2. Circuit selon la revendication 1, dans lequel le premier enroulement de sortie (ES1) comporte un premier noeud médian (NM1) situé au milieu du premier enroulement de sortie (ES1) et destiné à recevoir le signal de commande (SC), et
le deuxième enroulement de sortie (ES2) comporte un deuxième noeud médian (NM2) situé au milieu du deuxième enroulement de sortie (ES2) et couplé à la masse (GND).

3. Circuit selon la revendication 1 ou 2, dans lequel le nombre de spires (NSS1) du premier enroulement de sortie (ES1) est plus grand que le nombre de spires (NSE) de l'enroulement d'entrée (EE) et que le nombre de spires (NSS2) du deuxième enroulement de sortie (ES2).

4. Circuit selon l'une quelconque des revendications précédentes, dans lequel l'étage de traitement (8) comprend un amplificateur à transimpédance (AT) destiné à recevoir le signal interne (SI).

5. Circuit selon l'une quelconque des revendications précédentes, dans lequel la fréquence du signal d'entrée radiofréquence (SER) est de l'ordre de 60 GHz.

6. Démodulateur incorporant un circuit électronique de détection d'enveloppe (6) selon l'une quelconque des revendications précédentes.

7. Démodulateur selon la revendication 6, étant un démodulateur (5) de type de modulation par décalage d'amplitude.

8. Récepteur radiofréquence sans fil comprenant un démodulateur (5) selon la revendication 6 ou 7.

9. Appareil de communication sans fil comprenant un récepteur (2) radiofréquence sans fil selon la revendication 8.

## Patentansprüche

1. Elektronischer Schaltkreis zur Hüllkurvenerfassung, umfassend
eine Erfassungsstufe (7), die mindestens einen MOS-Transistor (T1, T2, T5, T6, T7) umfasst, der so konfiguriert ist, dass er ein Hochfrequenz-Eingangssignal (SER) empfängt und ein internes Signal (SI) auf Grundlage des Eingangssignals (SER) liefert, wobei die mittlere Gate-Vorspannung des mindestens einen Transistors (T1, T2, T5, T6, T7) durch ein Steuersignal (SC) gesteuert wird, und
eine Verarbeitungsstufe (8), die mit der Erfassungsstufe (7) gekoppelt und so konfiguriert ist, dass sie ein Niederfrequenz-Ausgangssignal (SSB) auf Grundlage des internen Signals (SI) liefert und das Steuersignal (SC) auf Grundlage des internen Signals (SI) liefert, sodass der Wert des Steuersignals (SC) abnimmt, wenn die mittlere Leistung des Eingangssignals (SER) zunimmt, und umgekehrt,
**dadurch gekennzeichnet, dass** die Erfassungsstufe (7) umfasst
einen ersten MOS-Transistor (T1) vom N-Typ und einen zweiten MOS-Transistor (T2) vom N-Typ, deren Drains (D1, D2) gemeinsam an die Verarbeitungsstufe (8) gekoppelt sind, und
einen Transformator (T3V), der eine Eingangswicklung (EE), die dazu bestimmt ist, das Eingangssignal (SER) zu empfangen, eine erste Ausgangswicklung (ES1), die an die Verarbeitungsstufe (8) und die Gates (G1, G2) des ersten und des zweiten Transistors (T1, T2) gekoppelt ist, und eine zweite Ausgangswicklung (ES2) umfasst, die an die Sources (S1, S2) des ersten und des zweiten Transistors (T1, T2) gekoppelt ist, wobei die erste Ausgangswicklung (ES1) dazu bestimmt ist, das Steuersignal (SC) zu empfangen.

2. Schaltkreis nach Anspruch 1, wobei die erste Ausgangswicklung (ES1) einen ersten mittleren Knoten (NM1) umfasst, der sich in der Mitte der ersten Ausgangswicklung (ES1) befindet und dazu bestimmt ist, das Steuersignal (SC) zu empfangen, und
die zweite Ausgangswicklung (ES2) einen zweiten mittleren Knoten (NM2) umfasst, der sich in der Mitte der zweiten Ausgangswicklung (ES2) befindet und an die Masse (GND) gekoppelt ist.

3. Schaltkreis nach Anspruch 1 oder 2, wobei die Anzahl der Windungen (NSS1) der ersten Ausgangswicklung (ES1) größer ist als die Anzahl der Windungen (NSE) der Eingangswicklung (EE) und als die Anzahl der Windungen (NSS2) der zweiten Ausgangswicklung (ES2).

4. Schaltkreis nach einem der vorstehenden Ansprüche, wobei die Verarbeitungsstufe (8) einen Transimpedanzverstärker (AT) umfasst, der dazu bestimmt ist, das interne Signal (SI) zu empfangen.

5. Schaltkreis nach einem der vorstehenden Ansprüche, wobei die Frequenz des Hochfrequenz-Eingangssignals (SER) in der Größenordnung von 60 GHz liegt.

6. Demodulator, der einen elektronischen Schaltkreis zur Hüllkurvenerfassung (6) nach einem der vorstehenden Ansprüche enthält.

7. Demodulator nach Anspruch 6, bei dem es sich um einen Demodulator (5) vom Typ mit Modulation durch Amplitudenumtastung handelt.

8. Drahtlos-Hochfrequenzempfänger, der einen Demodulator (5) nach Anspruch 6 oder 7 umfasst.

9. Drahtlos-Kommunikationsvorrichtung, die einen Drahtlos-Hochfrequenzempfänger (2) nach Anspruch 8 umfasst.

## Claims

1. An electronic envelope detection circuit, including a detection stage (7) including at least one MOS transistor (T1, T2, T5, T6, T7) configured to receive a radiofrequency input signal (SER) and to deliver an internal signal (SI) from the input signal (SER), the average gate biasing voltage of said at least one transistor (T1, T2, T5, T6, T7) being controlled by a control signal (SC), and
a processing stage (8) coupled to the detection stage (7) and configured to deliver a low-frequency output signal (SSB) from the internal signal (SI) and to deliver the control signal (SC) from the internal signal (SI), so that the value of the control signal (SC) decreases as the average power of the input signal (SER) increases, and vice versa,
**characterised by** the detection stage (7) comprising a first N-type MOS transistor (T1) and a second N-type MOS transistor (T2), the drains (Dl, D2) of which are coupled together to the processing stage (8), and
a transformer (T3V) including an input winding (EE) for receiving the input signal (SER), a first output winding (ES1) coupled to the processing stage (8) and to the gates (G1, G2) of the first and second transistors (T1, T2), and a second output winding (ES2) coupled to the sources (S1, S2) of the first and second transistors (T1, T2), the first output winding (ES1) being arranged to receive the control signal (SC).

2. The circuit according to claim 1, wherein the first output winding (ES1) includes a first median node (NM1) located in the middle of the first output winding (ES1) and arranged to receive the control signal (SC), and
the second output winding (ES2) includes a second median node (NM2) located in the middle of the second output winding (ES2) and coupled to the ground (GND).

3. The circuit according to claim 1 or 2, wherein the number of turns (NSS1) of the first output winding (ES1) is greater than the number of turns (NSE) of the input winding (EE) and than the number of turns (NSS2) of the second output winding (ES2).

4. The circuit according to any of the preceding claims, wherein the processing stage (8) comprises a transimpedance amplifier (AT) for receiving the internal signal (SI).

5. The circuit according to any of the preceding claims, wherein the frequency of the radiofrequency input signal (SER) is in the order of 60 GHz.

6. A demodulator incorporating an electronic envelope detection circuit (6) according to any of the preceding claims.

7. The demodulator according to claim 6, being a demodulator (5) of the amplitude shift keying type.

8. A wireless radiofrequency receiver comprising a demodulator (5) according to claim 6 or 7.

9. A wireless communication apparatus comprising a wireless radiofrequency receiver (2) according to claim 8.
